(19)

Europäisches
Patentamt
European
Patent Office
Office européen
des brevets

(11) **EP 4 250 428 A1**

(12) **EUROPEAN PATENT APPLICATION**
published in accordance with Art. 153(4) EPC

(43) Date of publication:
**27.09.2023 Bulletin 2023/39**

(21) Application number: **21894410.6**

(22) Date of filing: **20.10.2021**

(51) International Patent Classification (IPC):
**H01M 10/42** (2006.01)    **H01M 10/48** (2006.01)
**H02J 7/00** (2006.01)    **G01R 31/367** (2019.01)
**G01R 31/3828** (2019.01)    **G01R 31/3842** (2019.01)
**G01R 31/387** (2019.01)    **G01R 31/389** (2019.01)
**G01R 31/392** (2019.01)

(52) Cooperative Patent Classification (CPC):
**G01R 31/367; G01R 31/3828; G01R 31/3842;
G01R 31/387; G01R 31/389; G01R 31/392;
H01M 10/42; H01M 10/48; H02J 7/00**

(86) International application number:
**PCT/JP2021/038750**

(87) International publication number:
**WO 2022/107536 (27.05.2022 Gazette 2022/21)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **20.11.2020   JP 2020193213**

(71) Applicant: **Hitachi, Ltd.**
**Tokyo 100-8280 (JP)**

(72) Inventors:
• **KOMATSU, Daiki**
 **Tokyo 100-8280 (JP)**
• **NAKAO, Ryohhei**
 **Tokyo 100-8280 (JP)**
• **YAMAUCHI, Shin**
 **Tokyo 100-8280 (JP)**

(74) Representative: **MERH-IP Matias Erny Reichl
Hoffmann
Patentanwälte PartG mbB
Paul-Heyse-Strasse 29
80336 München (DE)**

(54)    **BATTERY CONTROL DEVICE AND PROGRAM**

(57)    A battery control device appropriately manages a storage battery. Therefore, a battery control device (100) includes a representative degradation rate calculation unit (116, 118) that calculates, based on terminal voltages (Vcell[ ]) of a plurality of battery cells connected in series, a representative degradation rate (SOHRave, SOHQave) that is a degradation rate of the whole of the plurality of battery cells, and an attention degradation rate extraction unit (120, 140) that acquires an attention degradation rate (SOHRmax, SOHQmin) that is a degradation rate of any of the plurality of battery cells, based on the representative degradation rate (SOHRave, SOHQave) and the respective terminal voltages (Vcell[ ]).

*FIG. 3*

EP 4 250 428 A1

**Description**

Technical Field

The present invention relates to a battery control device and a program.

Background Art

PTLs 1 to 3 below describe a technique related to control of a storage battery.

Citation List

Patent Literature

PTL 1: JP 2012-083123 A
PTL 2: JP 2006-242880 A
PTL 3: JP 2018-169284 A

Summary of Invention

Technical Problem

There is a demand for more appropriate management of the storage battery in the above-described technology.
The present invention has been made in view of the above circumstances, and an object thereof is to provide a battery control device and a program capable of appropriately managing a storage battery.

Solution to Problem

In order to solve the above problems, a battery control device of the present invention includes a representative degradation rate.calculation unit that calculates, based on terminal voltages of a plurality of battery cells connected in series, a representative degradation rate that is a degradation rate of the whole of the plurality of battery cells, and an attention degradation rate extraction unit that acquires an attention degradation rate that is a degradation rate of any of the plurality of battery cells based on the representative degradation rate and the respective terminal voltages.

Advantageous Effects of Invention

According to the present invention, the storage battery can be appropriately managed.

Brief Description of Drawings

[FIG. 1] FIG. 1 is a block diagram of a battery pack according to the preferred first embodiment.
[FIG. 2] FIG. 2 is a block diagram (1/2) of a main part of the battery control device.
[FIG. 3] FIG. 3 is a block diagram (2/2) of a main part of the battery control device.
[FIG. 4] FIG. 4 is a circuit diagram of an equivalent circuit model of a battery cell.
[FIG. 5] FIG. 5 is a block diagram illustrating details of a maximum SOHR arithmetic unit.
[FIG. 6] FIG. 6 is an example of a waveform diagram of each unit in the battery control device.
[FIG. 7] FIG. 7 is a block diagram of a minimum SOHQ arithmetic unit according to the preferred second embodiment.
[FIG. 8] FIG. 8 is an example of a waveform diagram of each unit according to the second embodiment.
[FIG. 9] FIG. 9 is a block diagram of a main part of a battery control device according to the third embodiment.

Description of Embodiments

[Premise of Embodiment]

In recent years, the number of battery cells that need to be managed by the battery controller has increased as the scale of multi-series and multi-parallel storage battery systems has increased. For this reason, as the size of the battery cell increases, the degree of degradation in the battery system also varies greatly, and a technique for identifying the most degraded battery is desired. In addition, in a moving body such as a vehicle, a microcomputer used for a battery controller is also difficult to perform large-scale arithmetic processing, and thus it is desired to identify degradation variations with a low arithmetic load.

According to the technology to which the content of PTL 1 described above is applied, it is considered that it is possible to determine a battery in which degradation has progressed the most after calculating a degradation rate (SOH) from individual sensor information. However, in a case where the load of the logic of the SOH calculation itself is heavy, it is difficult to use a small-scale microcomputer for the SOH calculation. On the other hand, in a case where a logic with a light load is applied to the SOH calculation itself, a small-scale microcomputer can be used, but accuracy cannot be secured. Therefore, in a preferred embodiment to be described later, it is intended to achieve both a low arithmetic load and high accuracy in identifying the degradation variation.

[First Embodiment]

<Configuration of battery pack 10>

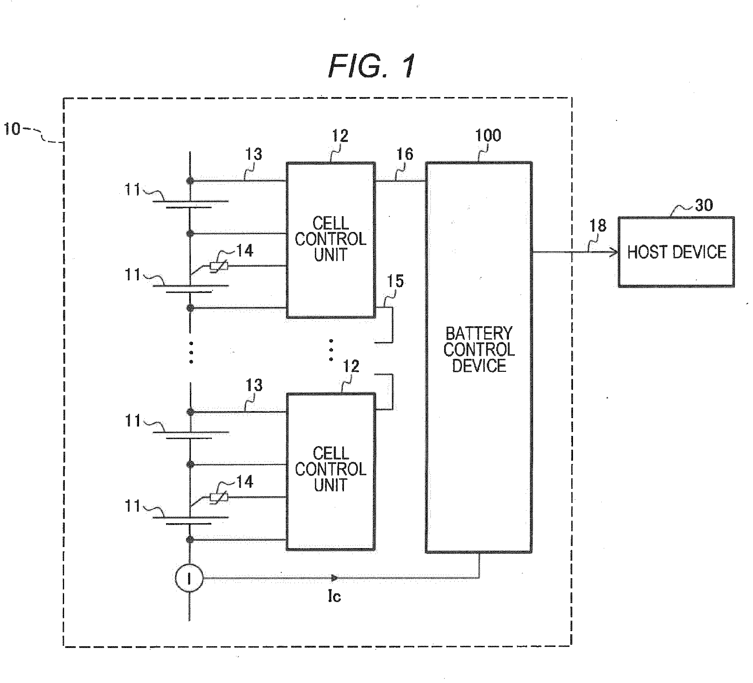

FIG. 1 is a block diagram of a battery pack 10 according to the preferred first embodiment.

In FIG. 1, the battery pack 10 includes a plurality of (M × N) battery cells 11 connected in series, a plurality of (M) cell control units 12, a plurality of voltage detection lines 13 connected to both ends of each battery cell 11, a plurality of (M) thermocouples 14, communication lines 16 and 18, a current sensor 17, and a battery control device 100 (computer).

The battery cell 11 is, for example, a lithium ion secondary battery, and form a group for every N cells (N is, for example, 12), and M groups are provided in the battery pack 10. The thermocouple 14 is attached to one battery cell 11 in each group, and measures the temperature of the battery cell 11. That is, the measurement result by the thermocouple 14 is regarded as a temperature of the N battery cells 11 belonging to the same group. However, the thermocouples 14 may be attached to all of the N battery cells 11 belonging to each group.

A plurality of (for example, N+1) voltage detection lines 13 and the thermocouple 14 are connected to each cell control unit 12. As a result, the cell control unit 12 detects the voltages of the N battery cells 11 connected in series. The detection result by the current sensor 17 is referred to as a cell current Ic. In addition, the cell control unit 12 executes balancing control or the like of the N battery cells 11 based on a command from the battery control device 100. Each of the M cell control units 12 is connected to the battery control device 100 via a ring bus 15 and a communication line 16. The battery control device 100 is connected to a host device 30 via the communication line 18.

When the battery pack 10 is mounted on a moving body such as a vehicle, for example, a controller area network (CAN) can be applied to the communication line 18. The battery control device 100 performs SOC (charging rate) estimation, degradation rate estimation control (SOH), and allowable power calculation based on voltage information and temperature information of each battery cell 11, current information of the current sensor 17, and the like supplied from each cell control unit 12. Then, these arithmetic results are transmitted to the host device 30 via the communication line 18 to control input/output and the like of the battery pack 10. In the example illustrated in FIG. 1, all the battery cells 11 are connected in series, but series circuits of the plurality of battery cells 11 may be further connected in parallel to form the battery pack 10.

<Configuration of main part of battery control device 100>

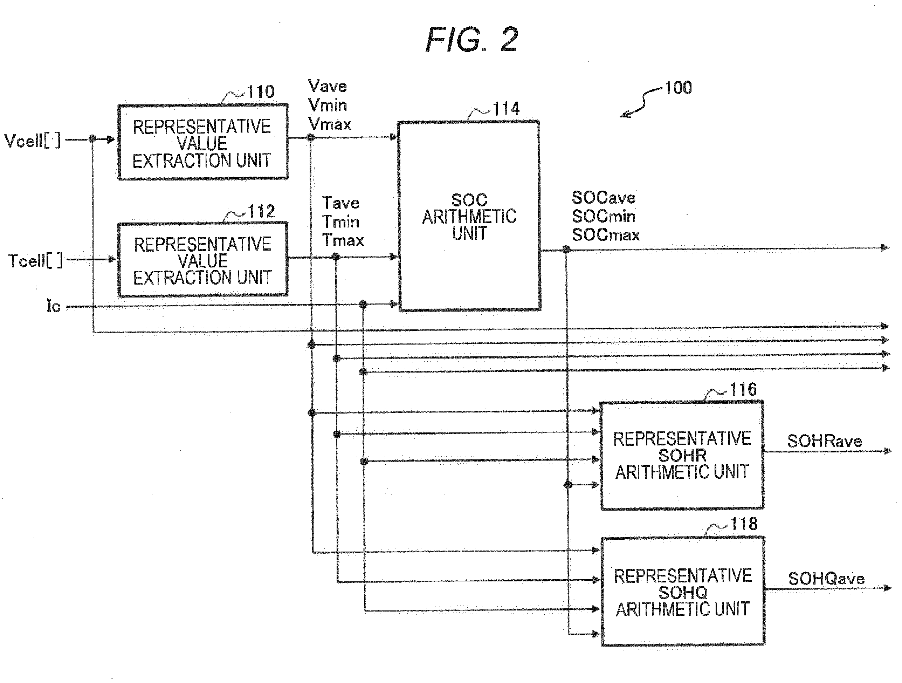

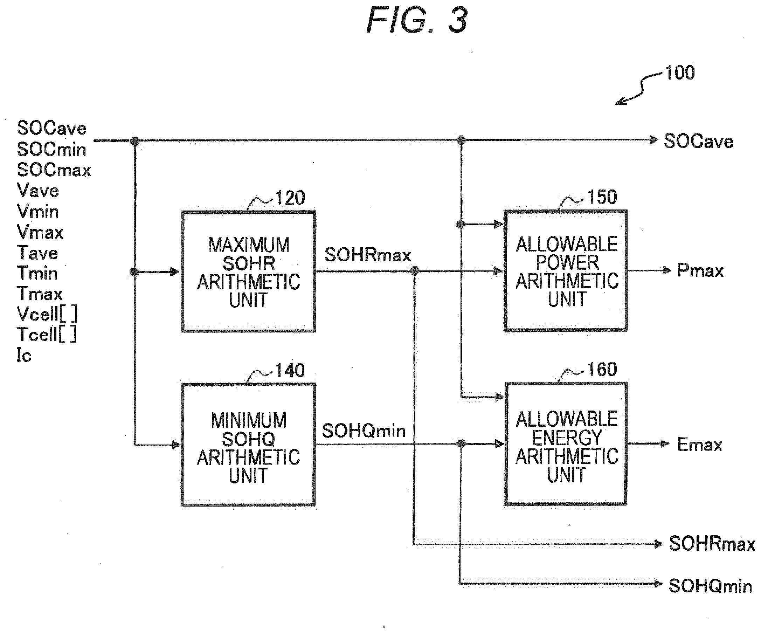

FIGS. 2 and 3 are block diagrams of main parts of the battery control device 100.

The battery control device 100 includes hardware as a general computer, such as a central processing unit (CPU), a digital signal processor (DSP), a random access memory (RAM), and a read only memory (ROM), and the ROM stores a control program executed by the CPU, a microprogram executed by the DSP, various pieces of data, and the like. In FIGS. 2 and 3, the inside of the battery control device 100 illustrates functions implemented by a control program, a microprogram, and the like as blocks.

That is, in FIG. 2, the battery control device 100 includes representative value extraction units 110 and 112, an SOC arithmetic unit 114, a representative SOHR arithmetic unit 116 (representative degradation rate calculation unit, representative degradation rate calculation means), and a representative SOHQ arithmetic unit 118 (representative degradation rate calculation unit, representative degradation rate calculation means). Further, in FIG. 3, the battery control device 100 includes a maximum SOHR arithmetic unit 120 (attention degradation rate extraction unit, attention degradation rate extraction means), a minimum SOHQ arithmetic unit 140 (attention degradation rate extraction unit, attention degradation rate extraction means), an allowable power arithmetic unit 150, and an allowable energy arithmetic unit 160.

In the following description, a matrix is expressed using square brackets. For example, a matrix of cell voltages that are terminal voltages of the M × N battery cells 11 is expressed as "Vcell[ ]". For example, a matrix of temperature detection values detected by the M thermocouples 14 is expressed as "Tcell[ ]".

(Representative value extraction units 110 and 112)

In FIG. 2, the representative value extraction unit 110 outputs a highest voltage Vmax that is the highest value among the cell voltages Vcell[ ], a lowest voltage Vmin that is the lowest value, and an average voltage Vave that is an average value of the cell voltages Vcell[ ]. In addition, the representative value extraction unit 112 outputs a highest temperature Tmax that is the highest value among the temperature detection values Tcell[ ], a lowest temperature Tmin that is the lowest value, and an average temperature Tave that is the average value of the temperature detection values Tcell[ ].

(SOC arithmetic unit 114)

The SOC arithmetic unit 114 outputs an SOCmax that is the maximum value, an SOCmin that is the minimum value, among SOCs (state of charge, charging rate) of the M × N battery cells 11, and an SOCave that is the average value of the SOCs of the M × N battery cells 11 based on the output signals of the representative value extraction units 110 and 112 and the cell current Ic.

(Representative SOHR arithmetic unit 116)

An index indicating the degree-of degradation of the internal resistance in the M × N battery cells 11 (see FIG. 1) is referred to as a resistance degradation rate SOHR. The representative SOHR arithmetic unit 116 calculates an average resistance degradation rate SOHRave (representative degradation rate, representative resistance degradation rate), that is a representative value of the resistance degradation rate SOHR, based on the output signals of the representative value extraction units 110 and 112 and the SOC arithmetic unit 114 and the cell current Ic. Since the calculated average resistance degradation rate SOHRave is a value calculated by regarding the battery pack 10 as one battery cell, the calculated average resistance degradation rate SOHRave is an average value of the resistance degradation rates SOHR of the individual battery cells 11. As a method for calculating the average resistance degradation rate SOHRave, for example, a method described in PTL 2 (JP 2006-242880) described above can be applied.

(Representative SOHQ arithmetic unit 118)

An index indicating the degradation rate of the capacity of each battery cell 11 is referred to as an SOHQ. The representative SOHQ arithmetic unit 118 calculates an average capacity degradation rate SOHQave (representative degradation rate, representative capacity degradation rate) that is a representative value of the SOHQ, based on the output signals of the representative value extraction units 110 and 112 and the SOC arithmetic unit 114 and the cell current Ic. Since the calculated SOHQave is a value calculated by regarding the battery pack 10 as one battery cell, the calculated SOHQave is an average value of the SOHQs of the individual battery cells 11. As a method for calculating the average capacity degradation rate SOHQave, for example, a method described in PTL 3 (JP 2018-169284) described above can be applied.

(Maximum SOHR arithmetic unit 120)

Next, in FIG. 3, the maximum SOHR arithmetic unit 120 calculates a maximum resistance degradation rate SOHRmax (attention degradation rate and attention resistance degradation rate) based on the output signals of the representative value extraction unit 112 and the SOC arithmetic unit 114 shown in FIG. 2, the cell voltage Vcell[ ], the cell current Ic, and the average resistance degradation rate SOHRave. Here, the maximum resistance degradation rate SOHRmax is an estimation value of the resistance degradation rate SOHR of the battery cell 11 in which the resistance degradation has progressed the most. Note that a detailed example of the calculation in the maximum SOHR arithmetic unit 120 will be described later.

(Minimum SOHQ arithmetic unit 140)

Next, the minimum SOHQ arithmetic unit 140 calculates an SOHQmin (attention degradation rate and attention capacity degradation rate) based on the output signals of the representative value extraction unit 112 and the SOC arithmetic unit 114, the cell voltage Vcell[ ], and the average capacity degradation rate SOHQave. Here, the SOHQmin is an estimation value of the SOHQ of the battery cell 11 in which capacity degradation has progressed the most. Note that a detailed example of the calculation in the maximum SOHR arithmetic unit 120 will be described in second embodiment described later.

(Allowable power arithmetic unit 150)

The allowable power arithmetic unit 150 outputs allowable power Pmax that is an estimation value of the maximum power that can be output by the battery pack 10 at the present time based on the output signals of the representative value extraction units 110 and 112 and the SOC arithmetic unit 114 illustrated in FIG. 2 and the maximum resistance degradation rate SOHRmax.

(Allowable energy arithmetic unit 160)

The allowable energy arithmetic unit 160 outputs allowable energy Emax that is an estimation value of the maximum energy that can be output by the battery pack 10 at the present time, based on the output signals of the representative value extraction units 110 and 112 and the SOC arithmetic unit 114 illustrated in FIG. 2 and the SOHQmin.
As described above, the SOCave, the maximum resistance degradation rate SOHRmax, the SOHQmin, the allowable power Pmax, and the allowable energy Emax calculated by the battery control device 100 are supplied to the host device 30 (see FIG. 1).
As described above, by obtaining the maximum resistance degradation rate SOHRmax and the minimum capacity degradation rate SOHQmin based on various parameters (Vmax, Vmin, Vave, Tmax, Tmin, Tave, and the like) input to the representative SOHR arithmetic unit 116 and the representative SOHQ arithmetic unit 118, the SOHRmax, the SOHQmin, and the like can be calculated with high accuracy and with a low arithmetic load.
In order to obtain the maximum resistance degradation rate SOHRmax and the minimum capacity degradation rate SOHQmin with high accuracy, it is also conceivable to calculate the SOC, the SOHR, and the SOHQ of each battery cell 11 without using the representative value extraction units 110 and 112 (see FIG. 2) and to identify the SOHRmax, the SOHQmin, and the like based on the arithmetic result. However, in such a method, since it is necessary to calculate the SOC, the SOHR, and the SOHQ of all the battery cells 11, an arithmetic load is large. On the other hand, according to the present embodiment, since the SOHRmax, the SOHQmin, and the like can be calculated based on a small number of representative values (Vmax, Vmin, Vave, Tmax, Tmin, Tave, and the like), the SOHRmax, the SOHQmin, and the like can be obtained with high accuracy and a low arithmetic load.

<Equivalent circuit model of battery cell 11>

As a premise to describe the details of the maximum SOHR arithmetic unit 120, an equivalent circuit model of the battery cell 11 will be described.

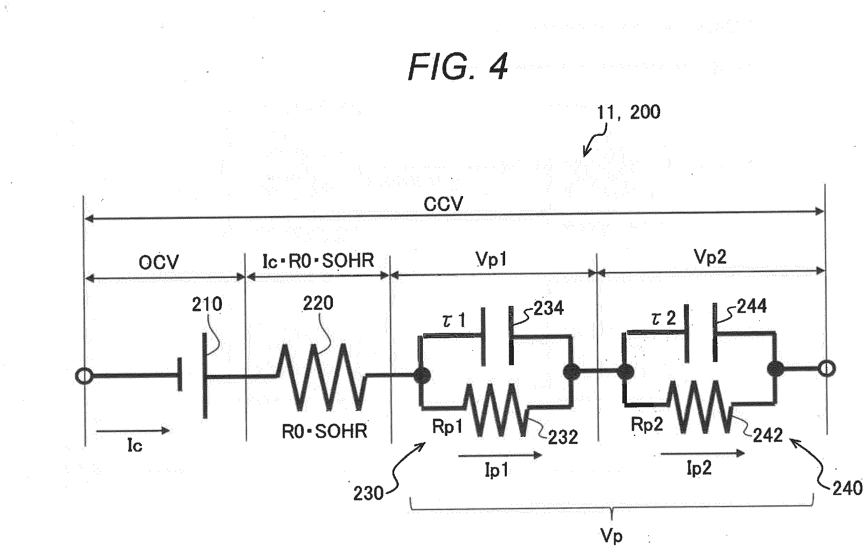

FIG. 4 is a circuit diagram of an equivalent circuit model 200 of the battery cell 11.
In FIG. 4, an equivalent circuit model 200 is a circuit in which a DC power supply 210, a resistor 220, and a parallel circuits 230 and 240 are connected in series. The parallel circuit 230 is a parallel circuit of a resistor 232 and a capacitor 234, and the parallel circuit 240 is a parallel circuit of a resistor 242 and a capacitor 244.
The cell voltage of the DC power supply 210 is referred to as an open circuit voltage OCV. The resistor 220 can be considered as an internal resistance of the battery cell 11 when the cell current Ic instantaneously flows, and a resistance value of the resistor 220 when the battery cell 11 is not used is R0. However, a result of multiplying the resistance value R0 by the resistance degradation rate SOHR according to the use time of the battery cell 11 is the resistance value of the resistor 220. That is, the voltage drop in the resistor 220 is $Ic \cdot R0 \cdot SOHR$.
A resistance value of the resistor 232 is Rp1, a time constant of the parallel circuit 230 is $\tau1$, and a current flowing through the resistor 232 is Ip1. In addition, a resistance value of the resistor 242 is Rp2, a time constant of the parallel circuit 240 is $\tau2$, and a current flowing through the resistor 242 is Ip2. The voltage drops in the parallel circuits 230 and 240 are referred to as partial polarization voltages Vp1 and Vp2, respectively, and the voltage drop obtained by combining the partial polarization voltages Vp1 and Vp2 is the polarization voltage Vp. The closed circuit voltage CCV of the battery cell 11 is equal to the sum of the open circuit voltage OCV, $Ic \cdot R0 \cdot SOHR$, and the polarization voltage Vp.

<Details of maximum SOHR arithmetic unit 120>

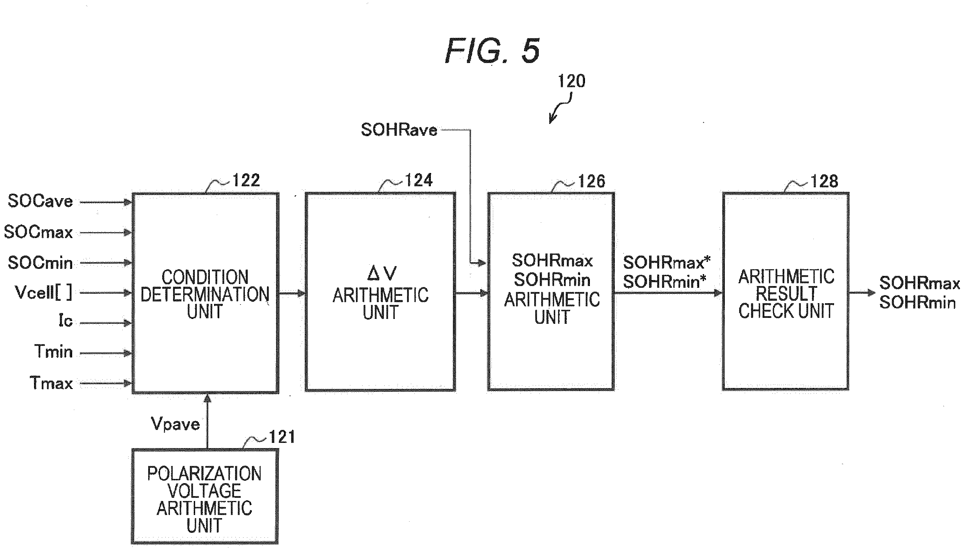

FIG. 5 is a block diagram illustrating details of the maximum SOHR arithmetic unit 120 described above.

In FIG. 5, the maximum SOHR arithmetic unit 120 includes a polarization voltage arithmetic unit 121, a condition determination unit.122, a $\Delta$V arithmetic unit 124, an arithmetic unit 126, and an arithmetic result check unit 128.

(Polarization voltage arithmetic unit 121)

The polarization voltage arithmetic unit 121 calculates an average polarization voltage Vpave that is an average value of polarization voltages Vp of all battery cells 11. As illustrated in FIG. 4, "Vp = CCV-Ic·R0·SOHR-OCV" holds in one battery cell 11. Therefore, the average polarization voltage Vpave that is the average value of the polarization voltage Vp can be obtained by "Vpave - Vave-Ic·R0·SOHRave-OCV". Here, since the resistance value R0 changes according to the SOC and the temperature, a table for obtaining the resistance value R0 based on the SOCave and the average temperature Tave may be prepared, and the resistance value R0 may be read from the table.

Then, the polarization voltage arithmetic unit 121 supplies the average polarization voltage Vpave to the condition determination unit 122. Furthermore, to the condition determination unit 122, the SOCmin, the SOCave, and the SOCmax are supplied from the SOC arithmetic unit 114 (see FIG. 2), the lowest temperature Tmin and the highest temperature Tmax are supplied from the representative value extraction unit 112, and the cell voltage Vcell[ ] and the cell current Ic are supplied from the cell control unit 12 (see FIG. 1).

(Condition determination unit 122)

The condition determination unit 122 determines whether the current timing is appropriate as a timing for calculating the maximum resistance degradation rate SOHRmax or the like based on the conditions CDA to CDG listed below. That is, when all the following conditions CDA to CDG are "true", the condition determination unit 122 notifies the $\Delta$V arithmetic unit 124 that the operation can be executed.

- 
$$\text{Condition CDA: } Icmin \leq |Ic| \leq Icmax, \text{ and } Ic\_z \leq Icmax\_z$$

where, Icmin is a current lower limit threshold value at which the calculation can be performed, and Icmax is a current upper limit threshold value at which the calculation can be performed. The battery control device 100 operates in units of control cycles of, for example, 10 milliseconds to 1 second. Ic_z is the cell current Ic in the previous control cycle, and is referred to as a "previous cell current". In addition, Icmax_z is a current upper limit threshold value Icmax applied in the previous control cycle, and is referred to as a "previous current upper limit threshold value". Note that also in various signal names described below, a signal name with "_z" added at the end indicates a signal in the previous control cycle. The condition CDA is intended to reduce the calculation error of the $\Delta$V arithmetic unit 124 by detecting the timing at which the cell current Ic greatly rises from a small value.

- 
$$\text{Condition CDB: } SOCminth \leq SOCmin$$

where SOCminth is a threshold value that determines a minimum value of SOCmin at which the calculation can be performed. The condition CDB is intended to avoid the SOC region where the SOCmin is less than the threshold value SOCmin in view of the fact that the resistance value R0 tends to increase as the SOC decreases in the region where the SOC is low.

- 
$$\text{Condition CDC: } SOCmax \leq SOCmaxth$$

where SOCmaxth is a threshold value that determines a maximum value of SOCmax at which the calculation can be performed. The condition CDC is intended to avoid an SOC region where the SOCmax exceeds the threshold value SOCmaxth in view of the fact that the resistance value R0 tends to increase as the SOC increases in a region where the SOC is high.

- 
$$\text{Condition CDD: } Tminth \leq Tmin$$

where, Tminth is a threshold value for determining a lowest value of the lowest temperature Tmin at which the calculation can be performed. Since the resistance value R0 tends to increase as the temperature decreases, the condition CDD is intended to avoid a temperature region where the lowest temperature Tmin is less than the threshold value Tminth.

$$\text{Condition CDE: } Tmax \le Tmaxth$$

where, Tmaxth is a threshold value that determines the highest value of the highest temperature Tmax at which the calculation can be performed. As described above, the polarization voltage arithmetic unit 121 reads the resistance value R0 from the table for obtaining the resistance value R0 based on the SOCave and the average temperature Tave. However, when the average temperature Tave exceeds the highest temperature recorded in the table, the resistance value R0 cannot be derived, and thus the calculation is limited based on the highest temperature Tmax.

$$\text{Condition CDF: } Tgap \le Tgapth$$

Here, Tgap is a value equal to "Tmax-Tmin", and is hereinafter referred to as a "temperature gap". Tgapth is a threshold value that determines the highest value of the temperature gap Tgap at which the calculation can be performed. When the variation in the temperature of each battery cell 11 in the battery pack 10 increases, the variation in the resistance value R0 also increases. When the ΔV arithmetic unit 124 calculates the maximum voltage difference ΔVmax, the minimum voltage difference ΔVmin, and the like (details will be described later), an arithmetic result as if "the variation in the degree of degradation of the resistance value R0 is large" may occur due to the variation in the resistance value R0 due to the temperature difference. Therefore, the calculation is limited based on the temperature gap Tgap.
$$\text{Condition CDG: } Vpave\_z \le Vpth$$

where, Vpave_z is an average polarization voltage Vpave (average value) in the previous control cycle, and is referred to as a "previous average polarization voltage". In addition, the threshold value Vpth (polarization voltage threshold value) is a threshold value that determines the highest value of the previous average polarization voltage Vpave_z at which the calculation can be performed. The maximum resistance degradation rate SOHRmax and the like are preferably calculated when the polarization voltage Vp is low. Therefore, the calculation is limited based on the average polarization voltage Vpave.

(ΔV arithmetic unit 124)

The ΔV arithmetic unit 124 calculates the maximum voltage difference ΔVmax, the minimum voltage difference ΔVmin, and the average voltage difference ΔVave by the following Expressions (1) to (4).

$$\Delta V[\ ] = Vcell[\ ] - Vcell\_start[\ ] ...(1)$$

$$\Delta Vmax = Max\ (\Delta V[\ ]) ...(2)$$

$$\Delta Vmin = Min\ (\Delta V[\ ]) ...(3)$$

$$\Delta Vave = Average\ (\Delta V[\ ]) ...(4)$$

In Expression (1), Vcell[ ] is a matrix of cell voltages in the current control cycle. In addition, Vcell_start[ ] is a matrix of cell voltages in the latest control cycle in which any of the above-described conditions CDA to CDG is changed from a state of "false" to a state of "true". Expression (2) indicates that the maximum value among the elements of the matrix ΔV[ ] is set to the maximum voltage difference ΔVmax, and Expression (3) indicates that the minimum value among the elements of the matrix ΔV[ ] is set to the minimum voltage difference ΔVmin. Expression (4) indicates that the average value of all elements of the matrix ΔV[ ] is set to the average voltage difference ΔVave.

(Arithmetic unit 126)

The arithmetic unit 126 calculates SOHRmax* and SOHRmin*, which are a provisional maximum value and a provisional minimum value of the SOHR, based on the following Expressions (5) to (8) . In the following Expressions (5) to (8), SOHRmax_z* and SOHRmin_z* are SOHRmax* and SOHRmin* in the previous control cycle. $W_{SOHRmax}$ and $W_{SOHRmin}$ are weights for weighted averaging.

$$SOHRmax\_New = SOHRave \times \Delta Vmax/\Delta Vave...(5)$$

$$SOHRmin\_New = SOHRave \times \Delta Vmin/\Delta Vave...(6)$$

$$SOHRmax* = (1-W_{SOHRmax}) \times SOHRmax\_z* + W_{SOHRmax} \times SOHRmax\_New...(7)$$

$$SOHRmin* = (1-W_{SOHRmin}) \times SOHRmin\_z* + W_{SOHRmin} \times SOHRmin\_New...(8)$$

(Arithmetic result check unit 128)

The arithmetic result check unit 128 checks the validity of SOHRmin* and SOHRmax* to output the minimum resistance degradation rate SOHRmin and the maximum resistance degradation rate SOHRmax based on the result. That is, when SOHRmin* > SOHRave, the arithmetic result check unit 128 determines that the arithmetic result of SOHRmin* is inappropriate to output the average resistance degradation rate SOHRave as the minimum resistance degradation rate SOHRmin. Otherwise, the arithmetic result check unit 128 outputs SOHRmin* as the minimum resistance degradation rate SOHRmin. Similarly, when SOHRmax* < SOHRave, the arithmetic result check unit 128 determines that the arithmetic result of SOHRmax* is inappropriate to output the average resistance degradation rate SOHRave as the maximum resistance degradation rate SOHRmax. Otherwise, the arithmetic result check unit 128 outputs SOHRmax* as the maximum resistance degradation rate SOHRmax.

<Specific example of arithmetic result>

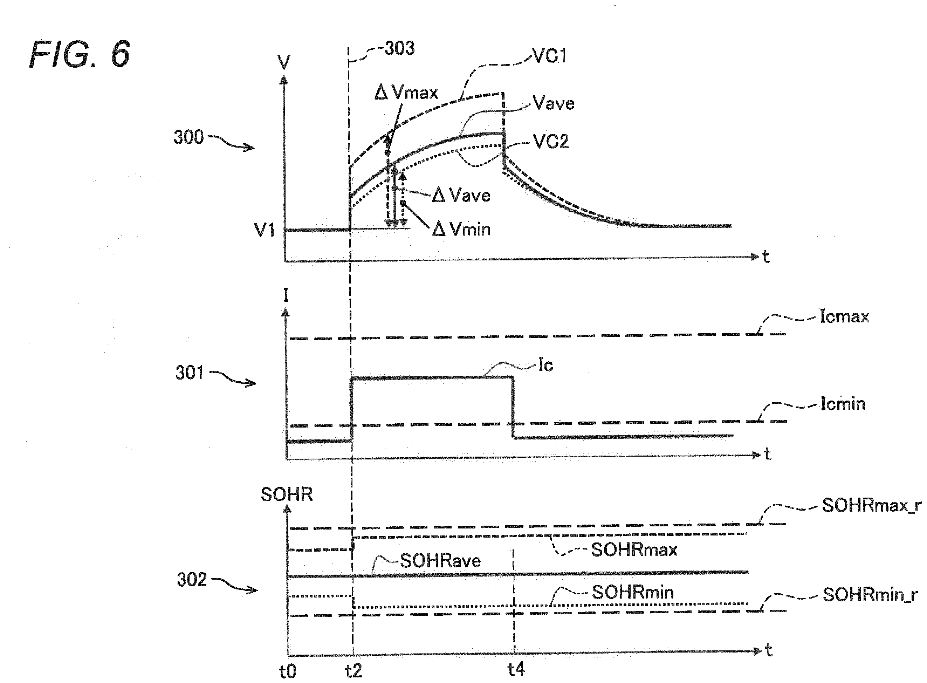

FIG. 6 is an example of a waveform diagram of each unit in the battery control device 100.
The horizontal axis of the graphs 300 to 302 of FIG. 6 is time t, and the vertical axis of the graphs 300 to 302 is voltage, current, and SOHR, respectively. Before time t2 of the graph 301, the cell current Ic is less than the current lower limit threshold value Icmin, but rises to a value of "Icmin ≤ Ic ≤ Icmax" at time t2, and falls to a value less than the current lower limit threshold value Icmin again at time t4.
In the entire period illustrated, the current lower limit threshold value Icmin and the current upper limit threshold value Icmax are constant. Therefore, the "previous current upper limit threshold value Icmax_z" described in the above-described condition CDA is equal to the current upper limit threshold value Icmax. Then, in the illustrated example, the condition CDA is satisfied in the period from time t2 to time t4. It is assumed that the other conditions CDB to CDG described above are also satisfied in the same period. Then, in the same period, the maximum SOHR arithmetic unit 120 (see FIG. 5) estimates the minimum resistance degradation rate SOHRmin, the maximum resistance degradation rate SOHRmax, and the like.
Here, among the M × N battery cells 11 (see FIG. 1), a cell having the highest resistance value R0 (see FIG. 4) is referred to as a cell 1 (not illustrated), and the cell voltage thereof is referred to as a VC1. A cell having the lowest resistance value R0 is referred to as a cell 2 (not illustrated), and the cell voltage thereof is referred to as a VC2. The graph 300 of FIG. 6 shows transitions of the average voltage Vave and the cell voltages VC1 and VC2. Since the cell current Ic is extremely small before time t2, the average voltage Vave and the cell voltages VC1 and VC2 have the same voltage level V1. However, this example is an example for facilitating the description, and the average voltage Vave and the cell voltages VC1 and VC2 do not necessarily coincide at time t2.
However, when the cell current Ic increases after time t2, the cell voltages VC1 and VC2 and the average voltage Vave vary as illustrated due to a difference in the resistance value R0 (see FIG. 4) and the like. The differences between the cell voltages VC1 and VC2 and the average voltage Vave at the time point of time t2 and the cell voltages VC1 and VC2 and the average voltage Vave at any time point t thereafter become the maximum voltage difference ΔVmax, the minimum voltage difference ΔVmin, and the average voltage difference ΔVave shown in the above-described Expressions (2) to (4), respectively.

As illustrated, in the period from time t2 to time t4, the maximum voltage difference ΔVmax is larger than the average voltage difference ΔVave, and the minimum voltage difference ΔVmin is smaller than the average voltage difference ΔVave. As described above, when the maximum voltage difference ΔVmax, the minimum voltage difference ΔVmin, and the average voltage difference ΔVave are calculated in the period from time t2 to time t4 when the cell voltages VC1 and VC2 and the average voltage Vave vary, it is possible to accurately grasp the variation in the resistance degradation rate SOHR from these values. In other words, it is possible to accurately obtain the maximum resistance degradation rate SOHRmax and the minimum resistance degradation rate SOHRmin.

The graph 302 shows transitions of the average resistance degradation rate SOHRave, the minimum resistance degradation rate SOHRmin, and the maximum resistance degradation rate SOHRmax obtained by calculation. In the graph 302, SOHRmax_r is a true value of the maximum resistance degradation rate SOHRmax, and SOHRmin_r is a true value of the minimum resistance degradation rate SOHRmin.

Note that, in the illustrated example, the SOHRmax and the SOHRmin change stepwise, but actually, as shown in the above Expressions (7) and (8), the SOHRmax and the SOHRmin by calculation approach true values SOHRmax_r and SOHRmin_r with the progress of the control cycle. As described above, after time t2, the accurate maximum resistance degradation rate SOHRmax and the accurate minimum resistance degradation rate SOHRmin are obtained based on variations in the average resistance degradation rate SOHRave and the cell voltage Vcell[ ].

[Second Embodiment]

Next, the preferred second embodiment will be described. In the following description, portions corresponding to the respective portions of the first embodiment described above are denoted by the same reference numerals, and the description thereof may be omitted.

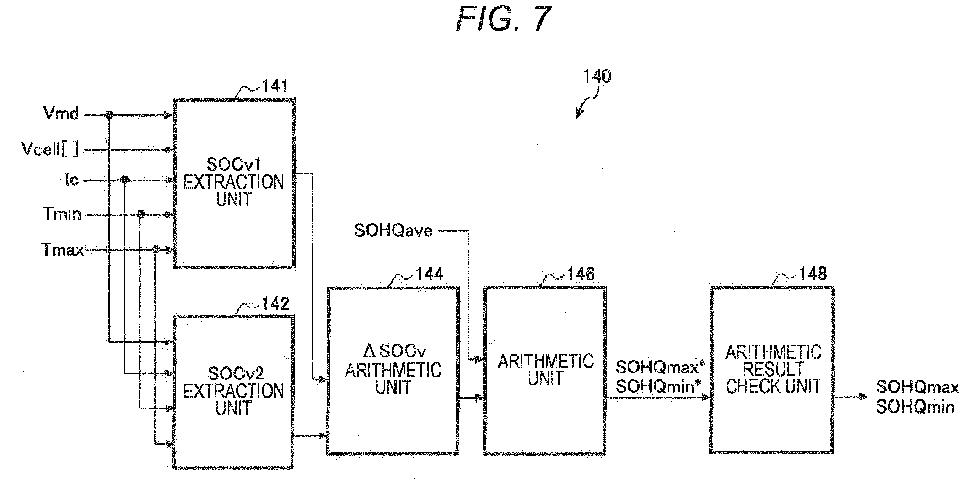

FIG. 7 is a block diagram of a minimum SOHQ arithmetic unit 140 according to the second embodiment. The battery pack of the second embodiment is configured to be similar to that of the first embodiment (FIGS. 1 to 5), but the minimum SOHQ arithmetic unit 140 is configured as shown in FIG. 7.

In FIG. 7, the minimum SOHQ arithmetic unit 140 includes an SOCv1 extraction unit 141, an SOCv2 extraction unit 142, a ΔSOCv arithmetic unit 144, an arithmetic unit 146, and an arithmetic result check unit 148.

In general, an SOC calculated based on an OCV estimated from a cell voltage during charging and discharging is referred to as an SOCv (charging rate). Then, a matrix of the SOCv corresponding to the cell voltage Vcell[ ] is referred to as an SOCv[ ]. Here, it is also conceivable to obtain the SOHQ[ ] that is a matrix of the SOHQ of all cells based on the SOCv[ ] and to obtain the minimum capacity degradation rate SOHQmin based on the SOHQ[ ]. However, calculating the SOHQs of all the cells requires a large arithmetic load. Therefore, in the present embodiment, a battery cell 11 that is considered to be severely degraded and have a small capacity is determined, and the minimum capacity degradation rate SOHQmin is calculated based on the state of the battery cell 11.

(SOCv1 extraction unit 141)

The SOCv1 extraction unit 141 is supplied with a model voltage Vmd, a cell voltage Vcell[ ], a cell current Ic, a lowest temperature Tmin, and a highest temperature Tmax. Here, the significance of parameters other than the model voltage Vmd is the same as that of the first embodiment. The model voltage Vmd is equal to a closed circuit voltage CCV when the resistance degradation rate SOHR is assumed to be the average resistance degradation rate SOHRave in the equivalent circuit model 200 (see FIG. 4). That is, the model voltage Vmd is a value obtained by the following Expression (9).

$$\mathrm{Vmd} = \mathrm{OCV} + \mathrm{Ic} \cdot \mathrm{R0} \cdot \mathrm{SOHRave} - \mathrm{Vp} \ldots (9)$$

The SOCv1 extraction unit 141 determines true/false for the following conditions CDH to CDK.

$$\text{Condition CDH:} \ |\mathrm{Vmd} - \mathrm{Vave}| \leq \mathrm{Vth}$$

where, Vth is a predetermined voltage difference threshold value. At a timing when a difference between the model voltage Vmd based on the equivalent circuit model 200 and the actual average voltage Vave is small, an error due to current input and an error due to polarization are small, and it is considered that highly accurate calculation can be performed. The condition CDH is intended to find such timing.

$$\text{Condition CDI:} \quad |Ic| \le Icth$$

where, Icth is a predetermined current threshold value. When the cell current Ic is small, the cell voltage Vcell[ ] approaches the open circuit voltage OCV. Therefore, the condition CDI is intended to estimate the SOCv1 in such a case.

$$\text{Condition CDJ:} \quad Tminth \le Tmin$$

where, Tminth is a threshold value for determining a lowest value of the lowest temperature Tmin at which the calculation can be performed. When the temperature detection value Tcell[ ] is low temperature, the resistance value R0 tends to increase as the temperature decreases, and thus the condition CDJ is intended to avoid this region in order to improve calculation accuracy. Note that the threshold value Tminth may be the same value as or different from the threshold value Tminth in the above-described condition CDD.

$$\text{Condition CDK:} \quad Tmax \le Tmaxth$$

where, Tmaxth is a threshold value that determines the highest value of the highest temperature Tmax at which the calculation can be performed. The condition CDK has a similar intention to the condition CDE described above. The threshold value Tmaxth may be the same value as or different from the threshold value Tmaxth in the above-described condition CDE.

Furthermore, when all the conditions CDH to CDK are "true", the SOCv1 extraction unit 141 calculates the SOCv1[ ] based on the following Expression (10).

$$SOCv1[\ ] = SOC\_OCV\_MAP\ (Vcell[\ ])...(10)$$

In Expression (10), SOC_OCV_MAP means a map for calculating the corresponding SOC using the open circuit voltage OCV as an input parameter. Therefore, Expression (10) means that the SOC of each battery cell 11 is calculated assuming that the cell voltage Vcell[ ] is equal to the open circuit voltage OCV, and the matrix of the calculated SOC is acquired as the SOCv1[ ]. The SOCv1[ ] acquired by the SOCv1 extraction unit 141 is held in a memory (not illustrated) provided in the SOCv1 extraction unit 141 for a certain period of time.

(SOCv2 extraction unit 142)

As in the SOCv1 extraction unit 141 described above, the SOCv2 extraction unit 142 is supplied with a model voltage Vmd, a cell voltage Vcell[ ], a cell current Ic, a lowest temperature Tmin, and a highest temperature Tmax.
Then, when all of the conditions CDI to CDK described above are "true", the SOCv2 extraction unit 142 calculates the SOCv2[ ] based on the following Expression (11).

$$SOCv2[\ ] = SOC\_OCV\_MAP\ (Vcell[\ ])...(11)$$

That is, the SOCv2[ ] is calculated in the same manner as the SOCv1 [ ], but when the SOCv2[ ] is calculated, the above-described condition CDH does not need to be satisfied. Since the above-described SOCv1[ ] is held for a certain period of time, accuracy is required, but the SOCv2[ ] is updated every time the calculation is established, so that accuracy similar to that of the SOCv1[ ] is not required. Therefore, in order to improve the arithmetic frequency, the above-described condition CDH is not applied in the calculation of the SOCv2[ ].

(ΔSOCv arithmetic unit 144)

The ΔSOCv arithmetic unit 144 calculates a ΔSOCv [ ], a ΔSOCvmax (maximum value), a ΔSOCvmin (minimum value), and a ΔSOCvave (average value) based on the following Expressions (12) to (15).

$$\Delta SOCv[\ ] = |SOCv1[\ ] - SOCv2[\ ]|...(12)$$

$$\Delta SOCvmax = Max\ (\Delta SOCv[\ ])...(13)$$

$$\Delta SOCvmin = Min\ (\Delta SOCv[\ ])...(14)$$

$$\Delta SOCvave = Average\ (\Delta SOCv[\ ])...(15)$$

Expression (12) means that respective elements of the SOCv1[ ] and the corresponding elements of the SOCv2[ ] are subtracted, and the array of the absolute values of the subtraction result is the $\Delta SOCv[\ ]$. Expression (13) indicates that the maximum value of the elements of the $\Delta SOCv[\ ]$ is the $\Delta SOCvmax$, and Expression (14) indicates that the minimum value of the elements of the $\Delta SOCv[\ ]$ is the $\Delta SOCvmin$. Expression (15) indicates that the average value of all elements of the $\Delta SOCv[\ ]$ is the $\Delta SOCvave$.

(Arithmetic unit 146)

The arithmetic unit 146 determines true/false for the following conditions CDL and CDM. Here, both $\Delta SOCvgapth$ (charging rate difference gap threshold value) and $\Delta SOCvth$ (charging rate difference threshold value) are predetermined threshold values.

- $$Condition\ CDL:\ \Delta SOCvmax - \Delta SOCvmin \geq \Delta SOCvgapth$$

- $$Condition\ CDM:\ \Delta SOCvave \geq \Delta SOCvth$$

Then, when at least one of the conditions CDL and CDM is "true", the arithmetic unit 146 calculates SOHQmax* and SOHQmin* that are a provisional maximum value and a minimum value of the SOHQ, based on the following Expressions (16) to (19).
In the following Expressions (16) to (19), SOHQmax_z* and SOHQmin_z* are SOHQmax* and SOHQmin_z* in the previous control cycle. $W_{SOHQmax}$ and $W_{SOHQmin}$ are weights for weighted averaging.

$$SOHQmax\_New = SOHQave \times \Delta SOCvmin/\Delta SOCvave...(16)$$

$$SOHQmin\_New = SOHQave \times \Delta SOCvmax/\Delta SOCvave...(17)$$

$$SOHQmax* = (1-W_{SOHQmax}) \times SOHQmax\_z* + W_{SOHQmax} \times$$
$$SOHQmax\_New...(18)$$

$$SOHQmin* = (1-W_{SOHQmin}) \times SOHQmin\_z* + W_{SOHQmin} \times$$
$$SOHQmin\_New...(19)$$

In addition, in a case where both of the conditions CDL and CDM described above are "false", the SOCv1 extraction unit 141 maintains the SOCv1[ ], and the SOCv2 extraction unit 142 reacquires the SOCv2[ ]. Furthermore, in a case where all the conditions CDH to CDK are "true", when at least one of the conditions CDL and CDM is "true", the SOCv1 extraction unit 141 reacquires the SOCv1[ ]. Furthermore, when the certain period of time described above elapses after the last acquisition of the SOCv1 [ ], the SOCv1 extraction unit 141 reacquires the SOCv1[ ] on condition that all the conditions CDH to CDK are "true".

(Arithmetic result check unit 148)

The arithmetic result check unit 148 checks the validity of SOHQmin* and SOHQmax* to output the minimum capacity degradation rate SOHQmin and the maximum capacity degradation rate SOHQmax based on the result. That is, when SOHQmin* > SOHQave, the arithmetic result check unit 148 determines that the arithmetic result of SOHQmin* is inappropriate to output the average capacity degradation rate SOHQave as the minimum capacity degradation rate SOHQmin. Otherwise, the arithmetic result check unit 148 outputs SOHQmin* as the minimum capacity degradation rate SOHQmin. Similarly, when SOHQmax* < SOHQave, the arithmetic result check unit 148 determines that the arithmetic result of SOHQmax* is inappropriate to output the average capacity degradation rate SOHQave as the maximum capacity degradation rate SOHQmax. Otherwise, the arithmetic result check unit 148 outputs SOHQmax* as the maximum capacity degradation rate SOHQmax.

<Specific example of arithmetic result>

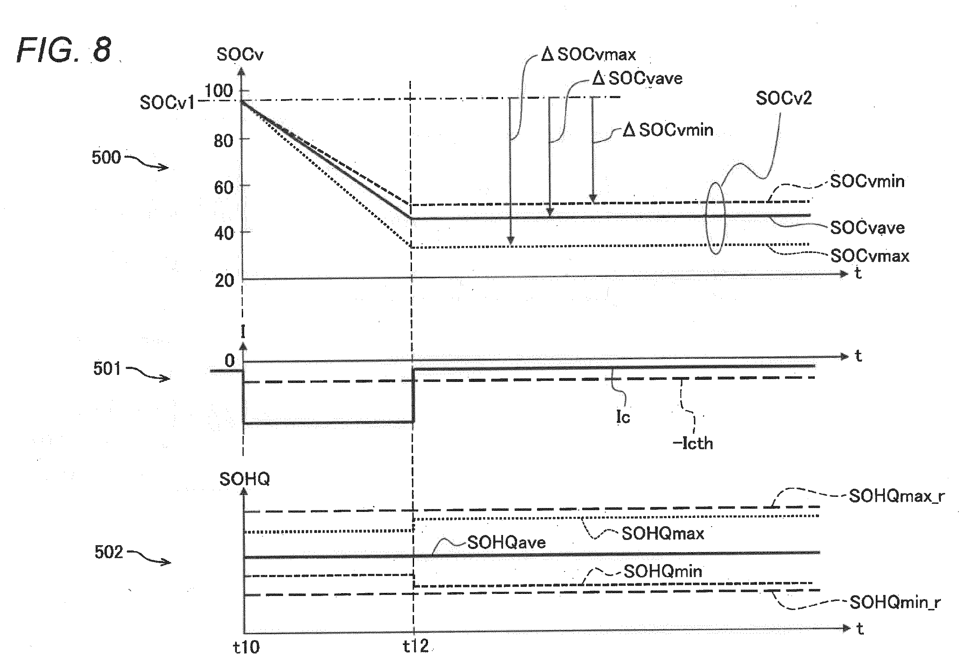

FIG. 8 is an example of a waveform diagram of each unit in the battery control device 100 of the present embodiment.
The horizontal axis of each of the graphs 500 to 502 of FIG. 8 is time t, and the vertical axes of the graphs 500 to 502 are an SOCv, a current, and an SOHQ, respectively. In the graph 501, a positive value is a charge current, and a negative value is a discharge current. Before time t10, the absolute value |Ic| of the cell current Ic is less than the Icth, but at time t10, the absolute value |Ic| rises to a value exceeding the current threshold value Icth. Thereafter, at time t12, the absolute value |Ic| falls to be equal to or less than the current threshold value Icth.
Here, among the M × N battery cells 11 (see FIG. 1), an SOCv of a cell having the minimum change in the SOCv with respect to the same current amount (cell having the maximum capacity) is referred to as an SOCvmin. In addition, an SOCv of a cell having the maximum change in the SOCv with respect to the same current amount (cell having the minimum capacitance) is referred to as an SOCvmax. The average value of the SOCv of the M × N battery cells 11 is referred to as an SOCvave.
When all the conditions CDH to CDK are satisfied immediately before time t10 when the cell current Ic rises, the SOCv1[ ] is calculated. In the example of the illustrated graph 500, at time t10, the SOCvmax, the SOCvmin, and the SOCvave are at the same level, and they also substantially coincide with the calculated SOCv1[ ]. Therefore, this level is referred to as "SOCv1" in the drawing. However, this example is an example for facilitating the description, and the SOCv of each battery cell 11 does not necessarily coincide with each other at time t10.
When the absolute value |Ic| of the cell current Ic increases from time t10 to time t12, the SOCvmax, the SOCvmin, and the SOCave vary as illustrated in the drawing during the period. The differences between the SOCv1 and the SOCvmax, the SOCv1 and the SOCvmin, and the SOCv1 and the SOCave are a ΔSOCvmax, a ΔSOCvmin, and a ΔSOCvave, respectively, shown in the Expressions (13) to (15). In the illustrated example, the SOCvmax corresponding to the battery cell 11 having the smallest capacity greatly deviates from the SOCvave, and the difference between the ΔSOCvmax and the ΔSOCvave increases. Similarly, the SOCvmin corresponding to the battery cell 11 having the largest capacity also deviates from the SOCvave, and the difference between the ΔSOCvmin and the ΔSOCvave also increases.
In the period from time t10 to time t12, the above-described condition CDI (|Ic| ≤ Icth) is not satisfied, so that neither the SOCv1[ ] nor the SOCv2[ ] is calculated. Then, at time t12, when the condition CDI is satisfied again and the other conditions CDJ and CDK are also satisfied, the SOCv2[ ] is calculated again. Then, in the illustrated example, each of the SOCvmax, the SOCvmin, and the SOCave after time t12 is equal to the SOCv2 calculated.
As described above, by acquiring the ΔSOCvmax corresponding to the battery cell 11 having the maximum change in SOCv and the ΔSOCvmin corresponding to the battery cell 11 having the minimum change in SOCv, it is possible to grasp the variation in the capacity degradation rate. Then, as shown in the above-described Expressions (16) to (19), it is possible to calculate the maximum capacity degradation rate SOHQmax and the minimum capacity degradation rate SOHQmin based on the ΔSOCvmax, the ΔSOCvmin, and the ΔSOCvave.
An example of the calculation result is illustrated in the graph 502. In the graph 502, SOHQmax_r and SOHQmin_r are true values of the maximum capacity degradation rate SOHQmax and the minimum capacity degradation rate SOHQmin, respectively. As shown in the drawing, according to the present embodiment, it is possible to obtain the maximum capacity degradation rate SOHQmax and the minimum capacity degradation rate SOHQmin close to true values with a small amount of calculation based on the ΔSOCvmax, the ΔSOCvmin, and the ΔSOCvave.

[Third Embodiment]

Next, the preferred third embodiment will be described. Note that, in the following description, portions corresponding to the respective portions of the above-described other embodiments are denoted by the same reference numerals, and the description thereof may be omitted.

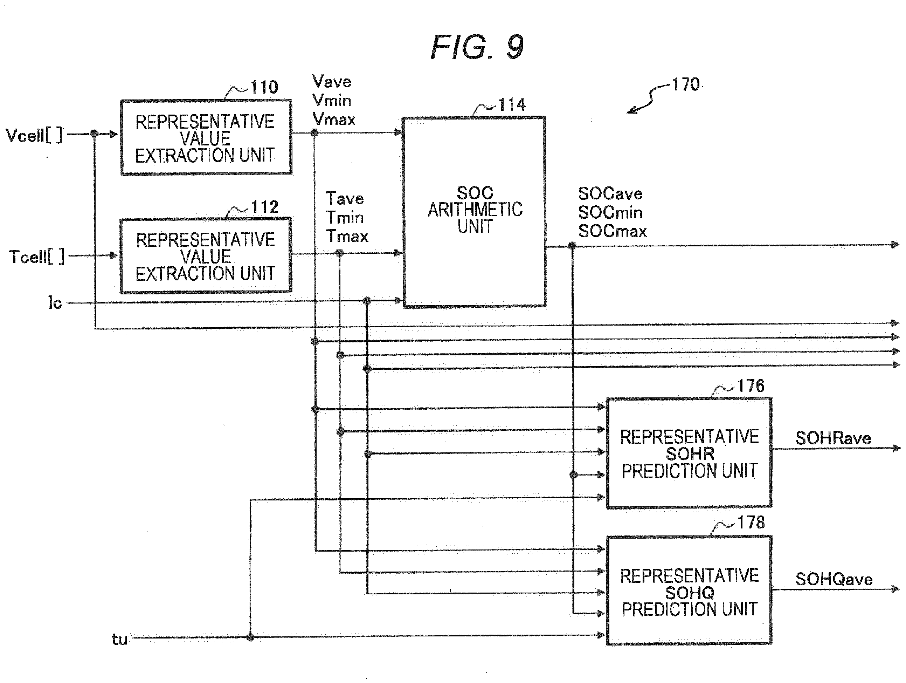

In the third embodiment, a battery control device 170 (computer) shown in FIG. 9 is applied instead of the battery control device 100 (FIGS. 2 and 3) of the first embodiment. FIG. 9 is a block diagram of a main part of battery control device 170.

The battery control device 170 includes a representative SOHR prediction unit 176 (representative degradation rate calculation unit, representative degradation rate calculation means) and a representative SOHQ prediction unit 178 (representative degradation rate calculation unit, representative degradation rate calculation means) instead of the representative SOHR arithmetic unit 116 and the representative SOHQ arithmetic unit 118 according to the first embodiment. The representative SOHR prediction unit 176 and the representative SOHQ prediction unit 178 output the prediction values of the average resistance degradation rate SOHRave and the average capacity degradation rate SOHQave, respectively, based on a use time tu of the battery pack 10. That is, the SOHRave and the SOHQave can be predicted to some extent even based on the use time tu. Therefore, in the present embodiment, the SOHRave and the SOHQave are predicted based on the use time tu.

As a method of predicting the SOHRave and the SOHQave, for example, a root law can be applied. The root law means that the degradation rate of the capacity or the like has a linear relationship with respect to the square root of the time or the charge/discharge amount, and for example, the SOHQave can be expressed as the following Expression (20). Expression (20) is the simplest expression, and k is a predetermined constant.

$$SOHQave = 1 - k \times \sqrt{(tu)} ...(20)$$

Various methods other than those described above are known as a method for calculating the resistance degradation rate SOHR or the capacity degradation rate SOHQ by utilizing the degradation prediction expression. Therefore, the resistance degradation rate SOHR or the capacity degradation rate SOHQ may be calculated by applying the degradation prediction expression by these methods.

In the first embodiment described above, in order for the representative value extraction units 110 and 112 to calculate the average resistance degradation rate SOHRave and the average capacity degradation rate SOHQave, it is preferable to make the battery cell 11 in the non-energized state for a certain period of time. However, when the battery cell 11 is repeatedly charged and discharged frequently, a preferable timing may not come in order to calculate the average resistance degradation rate SOHRave and the average capacity degradation rate SOHQave. According to the present embodiment, even in such a case, since the average resistance degradation rate SOHRave and the average capacity degradation rate SOHQave can be predicted based on the use time tu of the battery pack 10, the maximum resistance degradation rate SOHRmax and the minimum capacity degradation rate SOHQmin can be calculated based on these prediction results.

[Effects of embodiment]

According to the preferred embodiment as described above, the device includes a representative degradation rate calculation unit (116, 118, 176, 178) that calculates, based on terminal voltages (Vcell[ ]) of a plurality of battery cells 11 connected in series, a representative degradation rate (SOHRave, SOHQave) that is a degradation rate of the whole of the plurality of battery cells 11, and an attention degradation rate extraction unit (120, 140) that acquires an attention degradation rate (SOHRmax, SOHQmin) that is a degradation rate of any of the plurality of battery cells 11, based on the representative degradation rate (SOHRave, SOHQave) and the respective terminal voltages (Vcell[ ]). As a result, since the attention degradation rate (SOHRmax, SOHQmin) can be acquired with a small amount of calculation, the battery cell 11 can be appropriately managed.

In addition, the representative degradation rate (SOHRave, SOHQave) includes a representative resistance degradation rate (SOHRave) which is a degradation rate of the internal resistance of the whole of the plurality of battery cells 11, and the attention degradation rate (SOHRmax, SOHQmin) more preferably includes an attention resistance degradation rate (SOHRmax) which is a resistance increase rate of the battery cell 11 having the most degraded internal resistance. As a result, the degradation state of the internal resistance of the battery cell 11 can be more appropriately managed.

In addition, the representative degradation rate (SOHRave, SOHQave) includes a representative capacity degradation rate (SOHQave) which is a degradation rate of the capacity of the whole of the plurality of battery cells 11, and the attention degradation rate (SOHRmax, SOHQmin) more preferably includes an attention capacity degradation rate (SOHQmin) which is a capacity degradation rate of the battery cell 11 having the most degraded capacity. As a result, the degradation state of the capacity of the battery cell 11 can be more appropriately managed.

In addition, the attention degradation rate extraction unit (120, 140) more preferably calculates the attention degradation rate (SOHRmax, SOHQmin) on condition (CDB, CDC) that both the highest charging rate (SOCmax) and the lowest charging rate (SOCmin) among the charging rates of the plurality of battery cells 11 are within a predetermined charging rate range (SOCminth to SOCmaxth). When the charging rate (SOC) is high or low, the characteristics of the battery cell 11 may change as compared with the case where the charging rate (SOC) is intermediate between the two. Therefore, by calculating the attention degradation rate (SOHRmax, SOHQmin) while avoiding such a state, the degradation state of the capacity of the battery cell 11 can be managed more appropriately.

In addition, the attention degradation rate extraction unit (120, 140) more preferably calculates the attention degradation rate (SOHRmax, SOHQmin) on condition (CDJ, CDK) that both the highest temperature Tmax and the lowest temperature Tmin among the temperatures of the plurality of battery cells 11 are within a predetermined temperature range (Tminth to Tmaxth). When the temperature of the battery cell 11 is high or low, the characteristics of the battery cell 11 may change as compared with the case where the temperature is intermediate between the two. Therefore, by calculating the attention degradation rate (SOHRmax, SOHQmin) while avoiding such a state, the degradation state of the capacity of the battery cell 11 can be managed, more appropriately.

In addition, the attention degradation rate extraction unit (120, 140) more preferably calculates the attention degradation rate (SOHRmax, SOHQmin) on condition (CDI) that the cell current Ic flowing through the plurality of battery cells 11 falls within a predetermined current range ($|Ic| \leq Icth$). When the cell current Ic is small, the terminal voltages (Vcell[ ]) approaches the open circuit voltage OCV, so that the degradation state of the capacity of the battery cell 11 can be managed more appropriately.

The attention degradation rate extraction unit (120, 140) more preferably calculates the attention degradation rate (SOHRmax, SOHQmin) on condition (CDG) that the average value (Vpave) of the polarization voltages of the plurality of battery cells 11 is equal to or less than a predetermined polarization voltage threshold value (Vpth). As a result, the attention degradation rate (SOHRmax, SOHQmin) can be calculated when the polarization voltage is low, and the degradation state of the capacity of the battery cell 11 can be more appropriately managed.

In addition, the attention degradation rate extraction unit (120, 140) more preferably calculates the attention capacity degradation rate (SOHQmin) on the condition (CDM) that the average value ($\Delta$SOCvave) of the differences between the charging rates (SOCv) at the two timings of the plurality of battery cells 11 is equal to or larger than the predetermined charging rate difference threshold value ($\Delta$SOCvth). By calculating the attention capacity degradation rate (SOHQmin) in a state where the charging rate difference threshold value ($\Delta$SOCvth) is large, the influence of the error can be suppressed, and the degradation state of the capacity of the battery cell 11 can be managed more appropriately.

In addition, the attention degradation rate extraction unit (120, 140) more preferably calculates the attention capacity degradation rate (SOHQmin) on condition (CDL) that a difference ($\Delta$SOCvmax-$\Delta$SOCvmin) between the maximum value ($\Delta$SOCvmax) and the minimum value ($\Delta$SOCvmin) among the differences between the charging rates (SOCv) at the two timings of the plurality of battery cells 11 is equal to or larger than the predetermined charging rate difference gap threshold value ($\Delta$SOCvgapth). By calculating the attention capacity degradation rate (SOHQmin) in a state where the above-described difference ($\Delta$SOCvmax-$\Delta$SOCvmin) is large, the influence of the error can be suppressed, and the degradation state of the capacity of the battery cell 11 can be managed more appropriately.

[Modifications]

The present invention is not limited to the above-described embodiments, and various modifications are possible. The above-described embodiments have been exemplified for easy understanding of the present invention, and are not necessarily limited to those having all the described configurations. Moreover, it is possible to replace part of the configuration of an embodiment with the configuration of another embodiment, and it is also possible to add the configuration of another embodiment to the configuration of an embodiment. In addition, part of the configuration of each embodiment can be deleted, or another configuration can be added or replaced. In addition, the control lines and the information lines illustrated in the drawings indicate what is considered to be necessary for the description, and do not necessarily indicate all the control lines and the information lines necessary for the product. In practice, it may be considered that almost all configurations are connected to each other. Possible modifications to the above embodiment are, for example, as follows.
(1) Since the hardware of the battery control device 100, 170 according to the above embodiment can be realized by a general computer, a program or the like for executing the above-described various processes may be stored in a storage medium or distributed via a transmission path.
(2) Each processing in the above-described battery control device 100, 170 is described as software processing using a program in the above-described embodiment, but part or all of the processing may be replaced with hardware processing using an application specific integrated circuit (ASIC), a field programmable gate array (FPGA), or the like.

(3) In each of the above embodiments, both the maximum resistance degradation rate SOHRmax and the minimum capacity degradation rate SOHQmin are calculated, but when the degradation rate to be used is one of them, the other unnecessary one may not be calculated. For example, when the maximum resistance degradation rate SOHRmax is obtained for an application in which the instantaneous allowable power Pmax (see FIG. 3) is important as in a hybrid vehicle, the minimum capacity degradation rate SOHQmin may not be necessary. In applications where the allowable energy Emax (see FIG. 3) affecting the travelable distance is important as in an electric vehicle, when the minimum capacity degradation rate SOHQmin is obtained, the maximum resistance degradation rate SOHRmax may not be necessary.

(4) The minimum SOHQ arithmetic unit 140 according to each of the above embodiments calculates the SOCv1[ ] or the SOCv2[ ] on condition that the above-described conditions CDH to CDK or conditions CDI to CDK are "true". However, the above-described conditions CDB and CDC may be added as conditions for calculating the SOCv1[ ] or the SOCv2[ ].

(5) In each of the above embodiments, the maximum resistance degradation rate SOHRmax or the minimum capacity degradation rate SOHQmin of the most degraded battery cell 11 is obtained. However, the present invention is not limited to "the most degraded battery cell 11", but the maximum resistance degradation rate SOHRmax or the minimum capacity degradation rate SOHQmin may be obtained based on a cell voltage of an any battery cell 11.

Reference Signs List

11 battery cell
100, 170 battery control device (computer)
116, 176 representative SOHR arithmetic unit (representative degradation rate calculation unit, representative degradation rate calculation means)
118, 178 representative SOHQ arithmetic unit (representative degradation rate calculation unit, representative degradation rate calculation means)
120 maximum SOHR arithmetic unit (attention degradation rate extraction unit, attention degradation rate extraction means)
140 minimum SOHQ arithmetic unit (attention degradation rate extraction unit, attention degradation rate extraction means)
Ic cell current
tu use time
SOCv charging rate
Tmax highest temperature
Tmin lowest temperature
Vpth threshold value (polarization voltage threshold value) Vpave average polarization voltage (average value)
SOCmax highest charging rate
SOCmin lowest charging rate
SOHQave average capacity degradation rate (representative degradation rate, representative capacity degradation rate)
SOHQmin minimum capacity degradation rate (attention degradation rate and attention capacity degradation rate)
SOHRave average resistance degradation rate (representative degradation rate, representative resistance degradation rate) SOHRmax maximum resistance degradation rate (attention degradation rate and attention resistance degradation rate)
$\Delta$SOCvth charging rate difference threshold value
$\Delta$SOCvave average value
$\Delta$SOCvmax maximum value
$\Delta$SOCvmin minimum value
$\Delta$SOCvgapth charging rate difference gap threshold value

**Claims**

**1.** A battery control device comprising:

a representative degradation rate calculation unit that calculates, based on respective terminal voltages of a plurality of battery cells connected in series, a representative degradation rate that is a degradation rate of a whole of the plurality of battery cells; and

an attention degradation rate extraction unit that acquires an attention degradation rate that is a degradation rate of any of the plurality of battery cells based on the representative degradation rate and the respective terminal voltages.

2. The battery control device according to claim 1, wherein

the representative degradation rate includes a representative resistance degradation rate that is a degradation rate of an internal resistance of the whole of the plurality of battery cells, and

the attention degradation rate includes an attention resistance degradation rate that is a resistance increase rate of the battery cell having a most degraded internal resistance.

3. The battery control device according to claim 1, wherein

the representative degradation rate includes a representative capacity degradation rate that is a degradation rate of a capacity of the whole of the plurality of battery cells, and

the attention degradation rate includes an attention capacity degradation rate that is a capacity degradation rate of the battery cell having a most degraded capacity.

4. The battery control device according to any one of claims 1 to 3, wherein
the attention degradation rate extraction unit calculates the attention degradation rate on condition that both a highest charging rate and a lowest charging rate among charging rates of the plurality of battery cells are within a predetermined charging rate range.

5. The battery control device according to any one of claims 1 to 3, wherein
the attention degradation rate extraction unit calculates the attention degradation rate on condition that both a highest temperature and a lowest temperature among temperatures of the plurality of battery cells are within a predetermined temperature range.

6. The battery control device according to any one of claims 1 to 3, wherein
the attention degradation rate extraction unit calculates the attention degradation rate on condition that cell currents flowing through the plurality of battery cells are within a predetermined current range.

7. The battery control device according to any one of claims 1 to 3, wherein
the attention degradation rate extraction unit calculates the attention degradation rate on condition that an average value of polarization voltages of the plurality of battery cells is equal to or less than a predetermined polarization voltage threshold.

8. The battery control device according to claim 3, wherein
the attention degradation rate extraction unit calculates the attention capacity degradation rate on condition that an average value of differences between charging rates of the plurality of battery cells at two timings is equal to or larger than a predetermined charging rate difference threshold value.

9. The battery control device according to claim 3, wherein
the attention degradation rate extraction unit calculates the attention capacity degradation rate on condition that a difference between a maximum value and a minimum value among differences between charging rates of the plurality of battery cells at two timings is equal to or larger than a predetermined charging rate difference gap threshold value.

10. The battery control device according to any one of claims 1 to 3, wherein
the representative degradation rate calculation unit includes a function of predicting the representative degradation rate based on a use time of the plurality of battery cells.

11. A program causing a computer to function as:

a representative degradation rate calculation means that calculates, based on respective terminal voltages of a plurality of battery cells connected in series, a representative degradation rate that is a degradation rate of a whole of the plurality of battery cells; and

an attention degradation rate extraction means that acquires an attention degradation rate that is a degradation rate of any of the plurality of battery cells based on the representative degradation rate and the respective terminal voltages.

# FIG. 1

FIG. 2

# FIG. 3

SOCave
SOCmin
SOCmax
Vave
Vmin
Vmax
Tave
Tmin
Tmax
Vcell[ ]
Tcell[ ]
Ic

100

120 — MAXIMUM SOHR ARITHMETIC UNIT

SOHRmax

150 — ALLOWABLE POWER ARITHMETIC UNIT → Pmax

140 — MINIMUM SOHQ ARITHMETIC UNIT

SOHQmin

160 — ALLOWABLE ENERGY ARITHMETIC UNIT → Emax

→ SOCave

→ SOHRmax

→ SOHQmin

EP 4 250 428 A1

## FIG. 4

*FIG. 5*

120

SOHRave

EP 4 250 428 A1

FIG. 6

*FIG. 7*

EP 4 250 428 A1

FIG. 8

EP 4 250 428 A1

## FIG. 9

EP 4 250 428 A1

## INTERNATIONAL SEARCH REPORT

| International application No. |
| --- |
| **PCT/JP2021/038750** |

### A. CLASSIFICATION OF SUBJECT MATTER

**H01M 10/42**(2006.01)i; **H01M 10/48**(2006.01)i; **H02J 7/00**(2006.01)i; **G01R 31/367**(2019.01)i; **G01R 31/3828**(2019.01)i; **G01R 31/3842**(2019.01)i; **G01R 31/387**(2019.01)i; **G01R 31/389**(2019.01)i; **G01R 31/392**(2019.01)i
FI: G01R31/392; H01M10/48 P; H01M10/42 P; H01M10/48 301; H02J7/00 Y; G01R31/389; G01R31/3842; G01R31/3828; G01R31/387; G01R31/367

According to International Patent Classification (IPC) or to both national classification and IPC

### B. FIELDS SEARCHED

Minimum documentation searched (classification system followed by classification symbols)

H01M10/42; H01M10/48; H02J7/00; G01R31/367; G01R31/3828; G01R31/3842; G01R31/387; G01R31/389; G01R31/392

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| Y | JP 9-17459 A (MATSUSHITA ELECTRIC IND. CO., LTD.) 17 January 1997 (1997-01-17) paragraphs [0053]-[0062], fig. 3-5 | 1-6, 10-11 |
| A | | 7-9 |
| Y | WO 2013/018888 A1 (SANYO ELECTRIC CO., LTD.) 07 February 2013 (2013-02-07) paragraphs [0027], [0040], fig. 6, 8 | 1-6, 10-11 |
| Y | JP 2018-19552 A (NEC CORP.) 01 February 2018 (2018-02-01) paragraph [0022] | 1-6, 10-11 |
| Y | WO 2012/049852 A1 (TOYOTA JIDOSHA KK) 19 April 2012 (2012-04-19) paragraphs [0054]-[0057] | 2 |
| Y | WO 2012/169063 A1 (HITACHI VEHICLE ENERGY, LTD.) 13 December 2012 (2012-12-13) paragraph [0072] | 2 |

☑ Further documents are listed in the continuation of Box C.  ☑ See patent family annex.

| * Special categories of cited documents: | "T" later document published after the international filing date or priority date and not in conflict with the application but cited to understand the principle or theory underlying the invention |
| --- | --- |
| "A" document defining the general state of the art which is not considered to be of particular relevance | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **16 November 2021** | **30 November 2021** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**

International application No.

**PCT/JP2021/038750**

**C.     DOCUMENTS CONSIDERED TO BE RELEVANT**

| Category* | Citation of document, with indication, where appropriate, of the relevant passages | Relevant to claim No. |
|---|---|---|
| Y | WO 2018/066298 A1 (KK TOYOTA JIDOSHOKKI) 12 April 2018 (2018-04-12)<br>paragraph [0046] | 2 |
| Y | JP 2016-24170 A (HITACHI AUTOMOTIVE SYSTEMS, LTD.) 08 February 2016<br>(2016-02-08)<br>paragraph [0014] | 3 |
| Y | JP 2014-240807 A (MITSUBISHI MOTORS CORP.) 25 December 2014 (2014-12-25)<br>paragraph [0021] | 4-5 |
| Y | JP 2012-181037 A (MITSUBISHI HEAVY IND., LTD.) 20 September 2012 (2012-09-20)<br>paragraph [0029] | 6 |
| Y | JP 2015-118024 A (HITACHI AUTOMOTIVE SYSTEMS, LTD.) 25 June 2015 (2015-06-25)<br>paragraph [0014] | 10 |
| A | JP 2016-109653 A (HITACHI CHEMICAL CO., LTD.) 20 June 2016 (2016-06-20)<br>entire text, all drawings | 1-11 |
| A | JP 2003-59469 A (NISSAN MOTOR CO., LTD.) 28 February 2003 (2003-02-28)<br>entire text, all drawings | 1-11 |
| A | JP 2013-36936 A (TOYOTA JIDOSHA KK) 21 February 2013 (2013-02-21)<br>entire text, all drawings | 1-11 |
| A | US 2020/0225288 A1 (SAMSUNG ELECTRONICS CO., LTD.) 16 July 2020 (2020-07-16)<br>entire text, all drawings | 1-11 |

Form PCT/ISA/210 (second sheet) (January 2015)

INTERNATIONAL SEARCH REPORT
Information on patent family members

International application No.

**PCT/JP2021/038750**

| Patent document cited in search report | | | Publication date (day/month/year) | Patent family member(s) | | | Publication date (day/month/year) |
|---|---|---|---|---|---|---|---|
| JP | 9-17459 | A | 17 January 1997 | (Family: none) | | | |
| WO | 2013/018888 | A1 | 07 February 2013 | (Family: none) | | | |
| JP | 2018-19552 | A | 01 February 2018 | (Family: none) | | | |
| WO | 2012/049852 | A1 | 19 April 2012 | US | 2013/0200902 | A1 | |
| | | | | paragraphs [0073]-[0076] | | | |
| | | | | EP | 2629109 | A1 | |
| | | | | CN | 103154759 | A | |
| WO | 2012/169063 | A1 | 13 December 2012 | US | 2014/0111164 | A1 | |
| | | | | paragraph [0082] | | | |
| WO | 2018/066298 | A1 | 12 April 2018 | US | 2019/0229539 | A1 | |
| | | | | paragraph [0053] | | | |
| | | | | CN | 109791183 | A | |
| JP | 2016-24170 | A | 08 February 2016 | (Family: none) | | | |
| JP | 2014-240807 | A | 25 December 2014 | (Family: none) | | | |
| JP | 2012-181037 | A | 20 September 2012 | (Family: none) | | | |
| JP | 2015-118024 | A | 25 June 2015 | (Family: none) | | | |
| JP | 2016-109653 | A | 20 June 2016 | (Family: none) | | | |
| JP | 2003-59469 | A | 28 February 2003 | US | 2003/0030442 | A1 | |
| | | | | entire text, all drawings | | | |
| JP | 2013-36936 | A | 21 February 2013 | (Family: none) | | | |
| US | 2020/0225288 | A1 | 16 July 2020 | KR | 10-2020-0087494 | A | |
| | | | | entire text, all drawings | | | |

Form PCT/ISA/210 (patent family annex) (January 2015)

**EP 4 250 428 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012083123 A
- JP 2006242880 A
- JP 2018169284 A